(19) Europäisches Patentamt
European Patent Office
Office européen des brevets

(11) **EP 1 584 941 B1**

(12) **EUROPEAN PATENT SPECIFICATION**

(45) Date of publication and mention
of the grant of the patent:
**15.08.2007   Bulletin 2007/33**

(51) Int Cl.:
***G01R 31/36*** *(2006.01)*

(21) Application number: **05425180.6**

(22) Date of filing: **30.03.2005**

(54) **Device for measuring a battery energy in particular during charge/discharge of the battery**

Vorrichtung zur Energiemessung einer Batterie, insbesondere während des Ladens/Entladens der Batterie

Appareil pour mesurer l'énergie d'une batterie, en particulier pendant la charge/décharge de la batterie

(84) Designated Contracting States:
**AT BE BG CH CY CZ DE DK EE ES FI FR GB GR HU IE IS IT LI LT LU MC NL PL PT RO SE SI SK TR**

(30) Priority: **02.04.2004   IT   RM20040171**

(43) Date of publication of application:
**12.10.2005   Bulletin 2005/41**

(73) Proprietor: **Awelco INC. S.P.A.**
**83040 Conza (IT)**

(72) Inventors:
• **D'Avanzo Carmine**
**Awelco INC.S.P.A**
**83040 Conza (IT)**

• **De Rosa Guglielmo**
**Awelco INC.S.P.A**
**83040 Conza (IT)**

(74) Representative: **Iannone, Carlo Luigi et al**
**Barzanò & Zanardo Roma S.p.A.**
**Via Piemonte 26**
**00187 Roma (IT)**

(56) References cited:
**US-A- 5 440 221          US-B1- 6 404 166**
**US-B1- 6 501 249**

## Description

The present invention concerns a device for measuring, preferably ampere-hour, energy of a battery, in particular during battery charge/discharge.

More in detail, the present invention concerns a device apt to measure ampere-hours, in particular studied and implemented for use in the context of recharging devices for batteries or electrical accumulators, but which may be used in any case where it is necessary to measure the value of the energy that has been transferred from the charger to the battery.

In the following, the description will be directed to the application of the device, that is subject matter of the present invention, to a battery charger, but it is well evident that the same application has not to be considered as limited to this specific use.

Many different types of battery chargers are presently available in commerce, which are used for recharging electrical accumulators, or batteries, for industrial traction, for cars, or for several applications. These equipments provides battery recharge through more or less sophisticated systems. In fact, present battery chargers provide from the simple manual recharging current adjusting up to the complete automatism of the whole recharge process.

Said equipments are generally provided with a series of measuring instruments apt to indicate the battery charge state. For instance, said instruments may be a voltmeter and/or an amperometer. Moreover, signallers of several types are present, which allow to display values of instant current and/or instant voltage during recharging, and also a charge end state or other functions of the same charger. This signalling may also be reported on a display in terms of battery instant voltage, recharging instant current, etc.

Although the described instrumentations may also be very sophisticated, present battery chargers lack an instrument that measures and displays the value of ampere-hour of a charge, i.e. the value of the energy that has been transferred from the charger to the battery.

It is known to the skilled in the art that ampere-hour indicates the measurement unit of the battery capacity and it is defined as "the current suppliable during discharge, suitably delivered up to reach the final voltage". Therefore the ampere-hour is the product of the current intensity (measured in amperes) transmitted to the battery by the duration (in hours) of said current transmission. It is known that the quantity of electricity (capacity) of a battery or of a cell is normally expressed in ampere-hour [Ah]. Measuring this value is important since it determines the real battery state, that is the real capacity of storing energy.

US Patent No. US B1 6 501 249 a battery management system for measuring the charge state of a rechargeable battery and providing charge protection for the rechargeable battery, wherein the charge stored in the battery is measured without using a time base and without a time measurement or time period for sampling.

In view of the above, it appears evident the need for an available instrument measuring the ampere-hours, such as the one proposed according to the present invention.

In this context, it is included the solution proposed according to the present invention.

It is therefore an object of the present invention to propose a device for measuring the ampere-hours to be applied, in particular, to battery charger apparatuses.

It is therefore specific subject matter of the present invention a device for measuring a battery energy, in particular during charge/discharge of a battery, comprising supply means apt to be connected to a battery so as to make an electric current flow in/from the latter for one or more time intervals, and controlling and detecting means, characterised in that said controlling and detecting means is apt to detect the energy stored in said battery during a time period comprising at least one portion of said one or more time intervals.

Still according to the invention, said controlling and detecting means may be apt to detect said stored energy through an integration in said time period of said current flowing in/from the battery.

Furthermore according to the invention, said controlling and detecting means may comprise at least one microcontroller.

Always according to the invention, said device may further comprise enabling means, controlled by said controlling and detecting means, apt to enable or disable the flow of said current in/from the battery and said enabling means may comprise at least one thyristor, said controlling and detecting means controlling triggering and/or turning-off of said at least one thyristor.

Still according to the invention, said supply means may comprise a power supply unit, apt to provide a periodic voltage, said controlling and detecting means may comprise a unit of detection of the voltage provided by the power supply unit, and said controlling and detecting means may control triggering and/or turning-off of said at least one thyristor on the basis of the detected voltage provided by the power supply unit.

Furthermore according to the invention, said controlling and detecting means may comprise means of detection of the current flowing in said at least one thyristor.

Preferably according to the invention, said controlling and detecting means may control acoustic and/or visual signalling means, such as a display.

Always according to the invention, said supply means may be apt to be connected to a battery through pliers means, and said controlling and detecting means may comprise means of detection of at least one voltage applied to said pliers means.

Still according to the invention, said controlling and detecting means, when it detects that said at least one applied voltage is not positive, may be apt to control said enabling means so as to disable the flow of said current in/from the battery.

Furthermore according to the invention, said controlling and detecting means, when it detects that said at least one applied voltage reaches at least one corresponding threshold voltage value, may be apt to control said enabling means so as to disable the flow of said current in/from the battery.

Preferably according to the invention, said at least one corresponding threshold voltage value may be selectable by a user.

Always according to the invention, said controlling and detecting means may comprise interruption means activable by a user, following the activation of which said controlling and detecting means may control said enabling means so as to disable the flow of said current in/from the battery.

Furthermore according to the invention, said controlling and detecting means, when it detects that said time period reaches a corresponding threshold time value, may be apt to control said enabling means so as to disable the flow of said current in/from the battery.

Preferably according to the invention, said threshold time value may be selectable by a user.

Still according to the invention, said controlling and detecting means is apt to detect an energy efficiency $Re_t$, for each recharge-discharge cycle t, of said battery, equal to the ratio

$$Re_t = Wh_{0t}/Wh_{1t}$$

where $Wh_{0t}$ is the electric energy obtainable during a discharge of said battery at the cycle t and $Wh_{1t}$ is the electric energy needed for a recharge of said battery at the cycle t.

Furthermore according to the invention, said controlling and detecting means may be apt to detect the residual electric energy $Wh_{int}$ of said battery during a discharge step during the cycle t, equal to

$$Wh_{int} = Re_{t-1} \cdot Wh_{1t} - Wh_{ut}$$

where $Re_{t-1}$ is the energy efficiency of recharge-discharge of said battery during the preceding cycle t-1, $Wh_{1t}$ is the electric energy of recharge of said battery at the cycle t and $Wh_{ut}$ is the electric energy obtained from said battery before its complete discharge during said cycle t.

Always according to the invention, said controlling and detecting means may comprise means of detection of the temperature of said enabling means.

Preferably according to the invention, said controlling and detecting means may activate at least one cooling fan when it detects that said temperature reaches a first corresponding threshold temperature value.

Furthermore according to the invention, said controlling and detecting means, when it detects that said temperature reaches a second corresponding threshold temperature value, may be apt to control said enabling means so as to disable the flow of said current in/from the battery.

Still according to the invention, said controlling and detecting means may activate at least one cooling fan when it detects that said electric current flowing in/from the battery reaches a corresponding threshold current value.

The present invention will now be described, by way of illustration and not by way of limitation, according to its preferred embodiments, by particularly referring to the Figures of the enclosed drawings, in which:

Figure 1 shows a block diagram of a preferred embodiment of the device for measuring ampere-hours according to the present invention;
Figures 2A-2H show some detailed circuit diagrams of a first portion of the device of Figure 1;
Figures 3A-3B show some detailed circuit diagrams of a second portion of the device of Figure 1; and
Figure 4 shows a detailed circuit diagram of a third portion of the device of Figure 1.

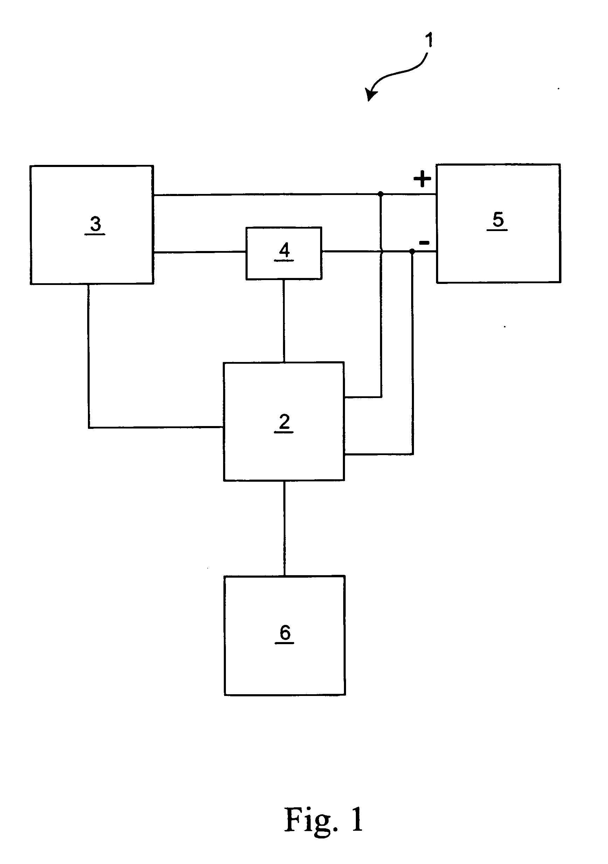

In the following description same references will be used for indicating alike elements in the Figures. Making reference to Figure 1, it is possible to observe the block diagram of a preferred embodiment of the device 1, that mainly comprise a control block 2, a power supply block 3, for supplying the device logic and providing the power supply for charging the battery 5, and a unit 4 for controlling the power supply current of said battery 5.

The control block 2 detects voltage and current charging the battery 5, taking account of delays and/or overloads, through a series of possible auxiliary circuits, not shown in the Figure. Through said detections, said control block 2 is capable to control the connection of the battery with ground, either or not short-circuiting the branch, through the current control unit 4, precisely calculating the value of the ampere-hours transmitted to the battery, and it is capable to display the latter on a display unit 6, such as for instance a display. In other words, through the control block 2, the device 1 may precisely calculate the current absorbed by the battery 5, and it may detect the charge times with maximum precision and synchronism. Finally, the control block 2 evaluates the ampere-hours transmitted on the basis of the data obtained from said detections.

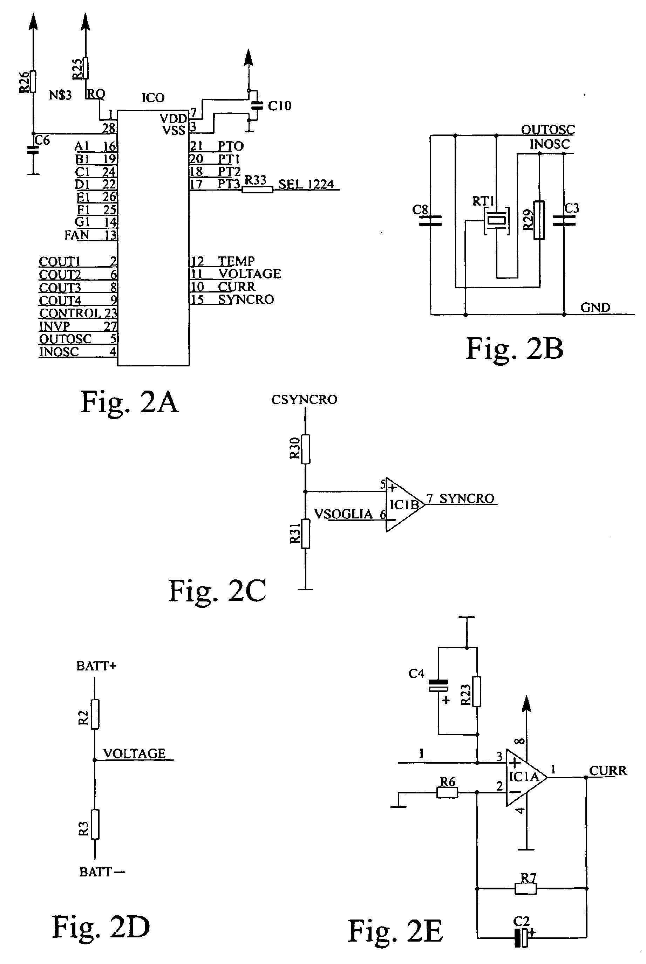

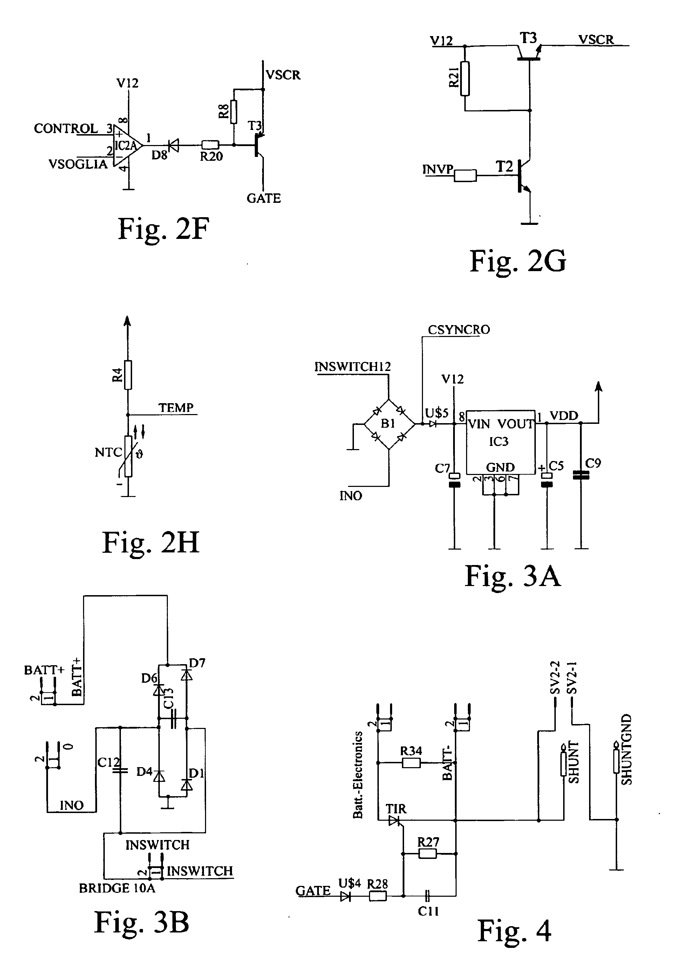

In the following Figures it is possible to observe some circuit diagrams of the preferred embodiment of the device according to the invention, based on the block diagram of Figure 2.

Figure 2A shows a microcontroller, referred to as IC0. This corresponds to a part of the control block 2 of Figure 2. Said microcontroller IC0 provides terminal groups suitable for specific functions. Terminals A1, B1, C1, D1, E1, F1, G1, and COUT 1 - 4 control a liquid crystal display, not shown in Figure, that allows displaying information on the battery charge, such as, for instance, voltage, charge time, and ampere-hours transmitted to the battery.

Terminals OUTOSC and INOSC are connected to the circuit shown in Figure 2B. This is a quartz resonant circuit, referred to as RT1, provided with a passive network, and it generates a clock signal for the microcontroller IC0.

In Figure 3A, a circuit is present that corresponds to a part of the power supply block 3 of Figure 1. This has two input terminals INSWICH12 and IN0 which represent a 12 Volt output of the secondary of a transformer (not shown in the Figure). Said two terminals are connected to the rectifier bridge B1. A stabilising circuit is present in cascade to said rectifier bridge B1, formed by the integrated circuit IC3, by a diode D1, and by capacitive components. IC3 is capable to generate a constant voltage VDD for supplying device logic parts.

Power supply circuit for recharging the battery (being also part of the power supply block 3 of Figure 1) is shown in Figure 3B. The connection to the battery positive terminal, through pliers BATT+, occurs through a rectifier bridge, made of diodes D1-D4, that rectifies the sinusoid coming from terminal taps IN0 and INSWITCH of the secondary of the aforecited transformer, not shown in the Figures.

The voltage is taken at the output of the rectifier bridge B1 of Figure 3A, through connection CSYNCRO, which voltage is processed by means of the circuit of Figure 2C (belonging to the control block 2 of Figure 1). The voltage of CSYNCRO is partitioned by the two resistors R1 and R2, placed at the input of the operational amplifier IC1-B, and it is compared with a threshold voltage VSOGLIA (preferably equal to the value of voltage drop on a conducting diode). As soon as the voltage CSYNCRO exceeds said threshold voltage VSOGLIA, the op-amp IC1-B generates an positive output signal, that is brought to the terminal SYNCRO of the microcontroller IC0, that converts said analog signal in a digital signal.

The just described circuit, that generates the signal SYNCRO, allows determining points wherein the voltage on the rectifier bridge is 0 Volt or lower than a certain threshold (equal to VSOGLIA). In other words, it is *zero-detect* circuit.

Besides the indication of the signal SYNCRO, the microcontroller IC0 detects the voltage on the battery, brought to the terminal VOLTAGE through the divider R4-R5 of Figure 2D (being part of the control block 2 of Figure 1) interposed between the terminals of the battery (i.e. between pliers BATT+ and BATT_ELETTRONICS- of the device), and the current transmitted to the battery, through a signal proportional to it on the terminal CURR.

Said current is proportional to that flowing on the thyristor TIR of Figure 4, where the circuit diagram of the current control unit 4 of Figure 1 is shown. Considering the circuit of Figure 2E (being also part of the control block 2 of Figure 1), detection of said current is possible through the op-amp IC1-A, in non inverting amplifier configuration, that is dedicated to amplify a current signal I, coming from a shunt (not shown in the Figures) placed between the contacts SHUNTGND, SHUNT, i.e. between SV2-1 and SV2-2, of Figure 4. The signal, proportional to said current I, at the output of the op-amp IC1-A is connected, as said before, to the terminal CURR of IC0, and it is converted from analog to digital.

Through detection of the battery voltage, of the instant charge current, passing through the thyristor TIR, of the value of voltage at the input of the thyristor TIR , the microcontroller IC0 is capable to determine the turn-on delay of TIR.

Turn-on of TIR is still driven by IC0, through the output CONTROL. The analog signal on the terminal CONTROL is still compared with the threshold voltage VSOGLIA by the op-amp IC2-A of the circuit of Figure 2F (that is still part of the control block 2 of Figure 1), and amplified in current by the transistor T1, the collector of which is connected to the gate of the thyristor TIR, and it is capable to provide it with the gate current needed for triggering it. In this way it is possible to precisely drive TIR, synchronising triggering with the supply half wave provided by the circuit of Figure 3B, and allowing IC0 to precisely calculate the instant in which the current passing through TIR, i.e. being transferred to the battery, is to be detected.

A system allowing the thyristor TIR to be powered off is also provided. This is obtained through the terminal INVP, driving the transistor T2 of the circuit of Figure 2G (being always part of the control block 2 of Figure 1), "mirror connected" with the transistor T3, that supplies the transistor T1 of Figure 2F through the branch VSCR. Therefore, by means of T2 it is possible to cut T1 off and turn TIR off.

When TIR is on, it allows the connection to ground of the battery negative terminal through first pliers BATT_ELETTRONICS-.

In Figure 4 further pliers BATT- is also shown that optionally allows the direct connection of the battery negative terminal to ground, enabling recharge with no control by the control block 2 of Figure 1.

Once TIR is on, it conducts and the battery is able to be recharged. The recharge current is detected in real time by IC0, through the circuit of Figure 2E, and it is stored so as to allow the ampere-hours to be calculated in a subsequent step. In fact, the microcontroller IC0 has the control of the triggering turn-off instants of the thyristor TIR, and therefore it may calculate the lapse of recharge time and hence the quantity of transferred energy (equal to the integration in time of the instant charge current).

Preferably, the microcontroller IC0 also provides a control allowing temperature effects on the thyristor TIR to be compensated. In particular, making reference to the circuit of Figure 2H (being part of the control block 2 of Figure 1), a resistor NTC, variable with temperature, is provided, that is connected as a divider with a resistor, placed in proximity of the transformer (not shown) and of the thyristor TIR. Said divider generates a voltage proportional to the temperature, that is brought to the terminal TEMP of IC0. IC0, through the terminal FAN, is capable to control a fan, allowing both the transformer and the thyristor TIR to be cooled.

During the recharge cycle, the microcontroller IC0 calculates the ampere-hour value of the energy stored in the battery, through substantially an integration in time of the charge current.

In particular, the value of the current transferred from the thyristor TIR (when triggered) to the battery is measured (or rather sampled) in each second. Such value is accumulated in a sum.

On completion of the charge cycle, the sum of the current values detected in each second is transformed in ampere-hours, i.e. amperes*hours, (i.e. the sum value, that is represented in amperes*seconds, is divided by 3600) and it is displayed on the display up to the power off of the battery charger.

Preferably, the thyristor TIR is definitely powered off (i.e. the charge cycle is interrupted) when a predetermined voltage value, possibly selectable by a user, is reached.

On the basis of the preceding description, it may be observed that the fundamental characteristics of the present invention is that of carrying out a synchronised detection of the charge (and possibly discharge) current of a battery and of the charge (and possibly discharge) time of a battery.

An advantage of the present invention is the fact that the ampere-hour meter may be also applied for measuring the number of ampere-hours during the discharge of the storage battery and therefore it is possible to detect the "energy efficiency" of said storage battery. In fact, as it is known, the energy efficiency is the "*ratio between the electric energy (Wh) obtainable during discharge and the one consumed during charge*". Therefore, such energy efficiency is equal to the ratio $Re = Wh_0/Wh_1$, where $Re$ is the energy efficiency, $Wh_0$ is the electric energy obtainable during discharge, and $Wh_1$ is the electric energy needed for recharge. Knowledge of the energy efficiency $Re$ (updated at each recharge because it is a function of the battery ageing) allows us to obtain the effective $Wh_0 = Wh_1 \cdot Re$, and hence by the ampere-hour meter according to the invention it is possible to measure the effective quantity of current available from a battery while the latter is more and more used.

The device according to the invention is extremely reliable, ensuring: protection against short-circuit and polarity reversal on pliers BATT+ and BATT_ELETTRONICA- (or BATT-), thermal protection, and automatic charge stop.

In particular, protection against short-circuit of the pliers BATT+ and BATT_ELETTRONICA- and against polarity reversal (connection of the pliers on reverse polarities of the battery) occurs through the thyristor that at the power-on of the battery charger is off. The microcontroller IC0 cyclically acquires the battery voltage and the output circuit remains off until the voltage remains null, whereby no voltage is present on the output pliers. The same thing occurs if a negative voltage is detected at the positive element of the pliers (i.e. the output pliers are reverse-connected to the battery poles), and the output circuit still remains off. Vice versa, when the microcontroller IC0 detects that the output pliers have been correctly connected to the battery, the charge cycle starts.

The thermal protection may comprise the interruption of the charge cycle (by suitably driving the thyristor TIR) until the predetermined limit temperature persists.

The microcontroller IC0 may also activate the fan for cooling the power circuit when a predetermined value of current provided by the thyristor TIR to the battery is exceeded.

Preferably, the charge cycle may further end I the case when the user, through an external intervention (for instance selection of a switch), decides to stop the battery charge, or in the case when a maximum charge time, possibly selectable by the user, expires.

The ampere-hour meter subject matter of the present invention, being capable to measure the energy stored in or output from a battery, may also be used for detecting the effective residual energy within the same battery. In fact, through said device, it is possible to calculate $Wh_1$, that is the electric energy obtainable during a charge, and $Wh_0$, that is the electric energy obtainable during the corresponding discharge. In this manner, the battery efficiency $Re$ is obtained as $Re = Wh_0/Wh_1$.

In the successive charge cycle t, the ampere-hour meter is capable to detect the new charge energy $Wh_{1t}$. Therefore, while the battery is in use, the ampere-hour meter is capable to evaluate the electric energy drawn from said battery, before the discharge at the discharge cycle t, $Wh_{ut}$, so obtaining the still residual one $Wh_{int}$ within the battery,

$$Wh_{int} = Re_{t-1} \cdot Wh_{1t} - Wh_{ut}$$

$Re_{t-1}$ is the energy efficiency of the preceding charge-discharge cycle t-1, while $Wh_{1t}$ is the electric energy stored in the battery 5 during the last charge step. Obviously, the energy efficiency $Re$ is updated at each charge-discharge cycle. In this way, it is possible to take account of the battery deterioration with time, which will tend to lessen the capacity of the same to store energy during the charge step.

The present invention has been described, by way of illustration and not by way of limitation, according its preferred embodiments, but it should be understood that those skilled in the art can make variations and/or changes, without so departing from the related scope of protection, as defined by the enclosed claims.

**Claims**

1. Device for measuring a battery energy, in particular during charge/discharge of a battery, comprising supply means (3) apt to be connected to a battery (5) so as to make an electric current flow in/from the latter for one or more time intervals, and controlling and detecting means (2) apt to detect the energy stored in said battery (5) during a time period comprising at least one portion of said one or more time intervals through an integration in said time period of said current flowing in/from the battery (5), **characterised in that** said energy is calculated by using a time base, whereby said current is periodically sampled and multiplied by a time length for obtaining a plurality of energy contributes and said energy is calculated by adding up said plurality of energy contributes.

2. Device according to claim 1, **characterised in that** said controlling and detecting means (2) comprises at least one microcontroller (ICO).

3. Device according to claim 1 or 2, **characterised in that** it further comprises enabling means (4), controlled by said controlling and detecting means (2), apt to enable or disable the flow of said current in/from the battery (5).

4. Device according to claim 3, **characterised in that** said enabling means (4) comprises at least one thyristor (TIR), said controlling and detecting means (2) controlling triggering and/or turning-off of said at least one thyristor (TIR).

5. Device according to claim 4, **characterised in that** said supply means (3) comprises a power supply unit (D1-D4), apt to provide a periodic voltage, **in that** said controlling and detecting means (2) comprises a unit (R1, R2, IC1-B) of detection of the voltage provided by the power supply unit (D1-D4), and **in that** said controlling and detecting means (2) controls triggering and/or turning-off of said at least one thyristor (TIR) on the basis of the detected voltage provided by the power supply unit (D1-D4).

6. Device according to claim 4 or 5, **characterised in that** said controlling and detecting means (2) comprises means (IC1-A) of detection of the current flowing in said at least one thyristor (TIR).

7. Device according to any one of the preceding claims, **characterised in that** said controlling and detecting means (2) controls acoustic and/or visual signalling means (6).

8. Device according to claim 7, **characterised in that** said acoustic and/or visual signalling means (6) comprises a display.

9. Device according to any one of the preceding claims, **characterised in that** said supply means (3) are apt to be connected to a battery (5) through pliers means (BATT+, BATT_ELETTRONICA-), and **in that** said controlling and detecting means (2) comprises means (R4, R5) of detection of at least one voltage applied to said pliers means (BATT+, BATT_ELETTRONICA-).

10. Device according to claim 9, when depending on claim 3, **characterised in that** said controlling and detecting means (2), when it detects that said at least one applied voltage is not positive, is apt to control said enabling means (4) so as to disable the flow of said current in/from the battery (5).

11. Device according to claim 9 or 10, when depending on claim 3, **characterised in that** said controlling and detecting means (2), when it detects that said at least one applied voltage reaches at least one corresponding threshold voltage value, is apt to control said enabling means (4) so as to disable the flow of said current in/from the battery (5).

12. Device according to claim 11, **characterised in that** said at least one corresponding threshold voltage value is selectable by a user.

13. Device according to any one of the preceding claims, when depending on claim 3, **characterised in that** said controlling and detecting means (2) comprises interruption means activable by a user, following the activation of which said controlling and detecting means (2) controls said enabling means (4) so as to disable the flow of said current in/from the battery (5).

14. Device according to any one of the preceding claims, when depending on claim 3, **characterised in that** said controlling and detecting means (2), when it detects that said time period reaches a corresponding threshold time value, is apt to control said enabling means (4) so as to disable the flow of said current in/from the battery (5).

15. Device according to claim 14, **characterised in that** said threshold time value is selectable by a user.

16. Device according to any one of the preceding claims, **characterised in that** said controlling and detecting means (2) is apt to detect an energy efficiency $Re_t$, for each recharge-discharge cycle t, of said battery (5), equal to the ratio

$$Re_t = Wh_{0t}/Wh_{1t}$$

where $Wh_{0t}$ is the electric energy obtainable during a discharge of said battery (5) at the cycle t and $Wh_{1t}$ is the electric energy needed for a recharge of said battery (5) at the cycle t.

17. Device according to claim 16, **characterised in that** said controlling and detecting means (2) is apt to detect the residual electric energy $Wh_{int}$ of said battery (5) during a discharge step during the cycle t, equal to

$$Wh_{int} = Re_{t-1} \cdot Wh_{1t} - Wh_{ut}$$

where $Re_{t-1}$ is the energy efficiency of recharge-dischargeof said battery (5) during the preceding cycle t-1, $Wh_{1t}$ is the electric energy of recharge of said battery (5) at the cycle t and $Wh_{ut}$ is the electric energy obtained from said battery (5) before its complete discharge during said cycle t.

18. Device according to any one of the preceding claims, when depending on claim 3, **characterised in that** said controlling and detecting means (2) comprises means (NTC) of detection of the temperature of said enabling means (4).

19. Device according to claim 18, **characterised in that** said controlling and detecting means (2) activates at least one cooling fan when it detects that said temperature reaches a first corresponding threshold temperature value.

20. Device according to claim 18 or 19, **characterised in that** said controlling and detecting means (2), when it detects that said temperature reaches a second corresponding threshold temperature value, is apt to control said enabling means (4) so as to disable the flow of said current in/from the battery (5).

21. Device according to any one of the preceding claims, **characterised in that** said controlling and detecting means (2) activates at least one cooling fan when it detects that said electric current flowing in/from the battery (5) reaches a corresponding threshold current value.

## Patentansprüche

1. Vorrichtung zum Messen von Batterieenergie, insbesondere während des Ladens/Entladens einer Batterie, wobei die Vorrichtung umfasst: ein Zufuhrmittel (3), das dafür geeignet ist, mit einer Batterie (5) verbunden zu werden, um zu veranlassen, dass für eines oder mehrere Zeitintervalle elektrischer Strom in die/aus der Letzteren fließt, und ein Steuerungs- und Erfassungsmittel (2), das dafür geeignet ist, während einer Zeitperiode, die wenigstens einen Teil der einen oder mehreren Zeitintervalle umfasst, über eine Integration des in die/aus der Batterie (5) fließenden Stroms in der Zeitperiode die in der Batterie (5) gespeicherte Energie (5) zu erfassen, **dadurch gekennzeichnet, dass** die Energie unter Verwendung einer Zeitbasis berechnet wird, wobei der Strom periodisch abgetastet und mit einer Zeitdauer multipliziert wird, um mehrere Energiebeiträge zu erhalten, und wobei die Energie durch Summieren der Vielzahl von Energiebeiträgen berechnet wird.

2. Vorrichtung nach Anspruch 1, **dadurch gekennzeichnet, dass** das Steuerungs- und Erfassungsmittel (2) mindestens einen Mikrocontroller (IC0) umfasst.

3. Vorrichtung nach Anspruch 1 oder 2, **dadurch gekennzeichnet, dass** sie ferner ein Freigabemittel (4) umfasst, das durch das Steuerungs- und Erfassungsmittel (2) gesteuert wird und dafür geeignet ist, den Fluss des Stroms in die/aus der Batterie (5) freizugeben oder zu sperren.

4. Vorrichtung nach Anspruch 3, **dadurch gekennzeichnet, dass** das Freigabemittel (4) wenigstens einen Thyristor (TIR) umfasst, wobei das Steuerungs- und Erfassungsmittel (2) das Zünden und/oder das Ausschalten des wenigstens einen Thyristors (TIR) steuert.

5. Vorrichtung nach Anspruch 4, **dadurch gekennzeichnet, dass** das Zufuhrmittel (3) eine Leistungsversorgungseinheit (D1-D4) umfasst, die dafür geeignet ist, eine periodische Spannung zu liefern, dass das Steuerungs- und Erfassungsmittel (2) eine Einheit (R1, R2, IC1-B) für die Erfassung der durch die Leistungsversorgungseinheit (D1-D4) gelieferten Spannung umfasst und dass das Steuerungs- und Erfassungsmittel (2) das Zünden und/oder das Ausschalten des mindestens einen Thyristors (TIR) auf der Grundlage der von der Leistungsversorgungseinheit (D1-D4) gelieferten erfassten Spannung steuert.

6. Vorrichtung nach Anspruch 4 oder 5, **dadurch gekennzeichnet, dass** das Steuerungs- und Erfassungsmittel (2) ein Mittel (IC1-A) zur Erfassung des in dem mindestens einen Thyristor (TIR) fließenden Stroms umfasst.

7. Vorrichtung nach einem vorangehenden Anspruch, **dadurch gekennzeichnet, dass** das Steuerungs- und Erfassungsmittel (2) ein akustisches und/oder optisches Signalisierungsmittel (6) steuert.

8. Vorrichtung nach Anspruch 7, **dadurch gekennzeichnet, dass** das akustische und/oder optische Signalisierungsmittel (6) eine Anzeige umfasst.

9. Vorrichtung nach einem vorangehenden Anspruch, **dadurch gekennzeichnet, dass** die Zufuhrmittel (3) dafür geeignet sind, über Zangenmittel (BATT+, BATT_ELETTRONICA-) mit einer Batterie (5) verbunden zu werden, und dass das Steuerungs- und Erfassungsmittel (2) ein Mittel (R4, R5) zur Erfassung der wenigstens einen an die Zangenmittel (BATT+, BATT_ELETTRONICA-) angelegten Spannung umfasst.

10. Vorrichtung nach Anspruch 9, wenn abhängig von Anspruch 3, **dadurch gekennzeichnet, dass** das Steuerungs- und Erfassungsmittel (2) dafür geeignet ist, das Freigabemittel (4) so zu steuern, dass es den Fluss des Stroms in die/aus der Batterie (5) sperrt, wenn es erfasst, dass die wenigstens eine angelegte Spannung nicht positiv ist.

11. Vorrichtung nach Anspruch 9 oder 10, wenn abhängig von Anspruch 3, **dadurch gekennzeichnet, dass** das Steuerungs- und Erfassungsmittel (2) dafür geeignet ist, das Freigabemittel (11) so zu steuern, dass es den Fluss des Stroms in die/aus der Batterie (5) sperrt, wenn es erfasst, dass die wenigstens eine angelegte Spannung wenigstens einen entsprechenden Spannungsschwellenwert erreicht.

12. Vorrichtung nach Anspruch 11, **dadurch gekennzeichnet, dass** der wenigstens eine entsprechende Spannungsschwellenwert durch einen Nutzer wählbar ist.

13. Vorrichtung nach einem vorangehenden Anspruch, wenn abhängig von Anspruch 3, **dadurch gekennzeichnet, dass** das Steuerungs- und Erfassungsmittel (2) ein durch einen Nutzer aktivierbares Unterbrechungsmittel umfasst, nach dessen Aktivierung das Steuerungs- und Erfassungsmittel (2) das Freigabemittel (4) so steuert, dass es den Fluss des Stroms in die/aus der Batterie (5) sperrt.

14. Vorrichtung nach einem vorangehenden Anspruch, wenn abhängig von Anspruch 3, **dadurch gekennzeichnet, dass** das Steuerungs- und Erfassungsmittel (2) dafür geeignet ist, das Freigabemittel (4) so zu steuern, dass es den Fluss des Stroms in die/aus der Batterie (5) sperrt, wenn es erfasst, dass die Zeitperiode einen entsprechenden Zeitschwellenwert erreicht.

15. Vorrichtung nach Anspruch 14, **dadurch gekenn-**

**zeichnet, dass** der Zeitschwellenwert durch einen Nutzer wählbar ist.

16. Vorrichtung nach einem vorangehenden Anspruch, **dadurch gekennzeichnet, dass** das Steuerungs- und Erfassungsmittel (2) dafür geeignet ist, für jeden Lade-Entlade-Zyklus t einen energetischen Wirkungsgrad $Re_t$ der Batterie (5) zu erfassen, der gleich dem Verhältnis

$$Re_t = Wh_{0t}/Wh_{1t}$$

ist, wobei $Wh_{0t}$ die während einer Entladung der Batterie (5) in dem Zyklus t erreichbare Elektroenergie ist und $Wh_{1t}$ die für eine Nachladung der Batterie (5) in dem Zyklus t benötigte Elektroenergie ist.

17. Vorrichtung nach Anspruch 16, **dadurch gekennzeichnet, dass** das Steuerungs- und Erfassungsmittel (2) dafür geeignet ist, während eines Entladungsschritts während des Zyklus t die Restelektroenergie $Wh_{int}$ der Batterie (5) zu erfassen, die gleich

$$Wh_{int} = Re_{t-1} \cdot Wh_{1t} - Wh_{ut}$$

ist, wobei $Re_{t-1}$ der energetische Wirkungsgrad der Nachladung/Entladung der Batterie (5) während des vorherigen Zyklus t-1 ist, $Wh_{1t}$ die Elektroenergie der Nachladung der Batterie (5) in dem Zyklus t ist und $Wh_{ut}$ die während des Zyklus t von der Batterie (5) vor ihrer vollständigen Entladung erhaltene Elektroenergie ist.

18. Vorrichtung nach einem vorangehenden Anspruch, wenn abhängig von Anspruch 3, **dadurch gekennzeichnet, dass** das Steuerungs- und Erfassungsmittel (2) ein Mittel (NTC) zur Erfassung der Temperatur des Freigabemittels (4) umfasst.

19. Vorrichtung nach Anspruch 18, **dadurch gekennzeichnet, dass** das Steuerungs- und Erfassungsmittel (2) wenigstens einen Lüfter aktiviert, wenn es erfasst, dass die Temperatur einen ersten entsprechenden Temperaturschwellenwert erreicht.

20. Vorrichtung nach Anspruch 18 oder 19, **dadurch gekennzeichnet, dass** das Steuerungs- und Erfassungsmittel (2) dafür geeignet ist, das Freigabemittel (4) so zu steuern, dass es den Fluss des Strom in die/aus der Batterie (5) sperrt, wenn es erfasst, dass die Temperatur einen zweiten entsprechenden Temperaturschwellenwert erreicht.

21. Vorrichtung nach einem vorangehenden Anspruch, **dadurch gekennzeichnet, dass** das Steuerungs- und Erfassungsmittel (2) mindestens einen Lüfter aktiviert, wenn es erfasst, dass der in die/aus der Batterie (5) fließende elektrische Strom einen entsprechenden Stromschwellenwert erreicht.

**Revendications**

1. Dispositif de mesure de l'énergie d'une batterie, en particulier pendant la charge/la décharge d'une batterie, comprenant des moyens d'alimentation (3) aptes à être connectés à une batterie (5) afin de faire circuler un courant électrique vers/depuis cette dernière pendant un ou plusieurs intervalles de temps, et des moyens de commande et de détection (2) aptes à détecter l'énergie stockée dans ladite batterie (5) pendant une période de temps comprenant au moins une partie desdits un ou plusieurs intervalles de temps par une intégration au cours de ladite période de temps dudit courant circulant vers/depuis la batterie (5), **caractérisé en ce que** ladite énergie est calculée en utilisant une base temporelle, ce qui fait que ledit courant est périodiquement échantillonné et multiplié par une longueur de temps permettant d'obtenir une pluralité de contributions d'énergie et ladite énergie est calculée en ajoutant ladite pluralité de contributions d'énergie.

2. Dispositif selon la revendication 1, **caractérisé en ce que** lesdits moyens de commande et de détection (2) comprennent au moins un microcontrôleur (ICO).

3. Dispositif selon la revendication 1 ou 2, **caractérisé en ce qu'**il comprend en outre des moyens d'autorisation (4), commandés par lesdits moyens de commande et de détection (2), aptes à autoriser ou non la circulation dudit courant vers/à partir de la batterie (5).

4. Dispositif selon la revendication 3, **caractérisé en ce que** lesdits moyens d'autorisation (4) comprennent au moins un thyristor (TIR), lesdits moyens de commande et de détection (2) commandant le déclenchement et/ou le blocage dudit au moins un thyristor (TIR).

5. Dispositif selon la revendication 4, **caractérisé en ce que** lesdits moyens d'alimentation (3) comprennent une unité d'alimentation (D1-D4), apte à fournir une tension périodique, dans lequel lesdits moyens de commande et de détection (2) comprennent une unité (R1, R2, IC1-B) de détection de la tension fournie par l'unité d'alimemation (D1-D4), et **en ce que** lesdits moyens de commande et de détection (2) commandent le déclenchement et/ou le blocage dudit au moins un thyristor (TIR) sur la base de la tension détectée fournie par l'unité d'alimentation (D1-D4).

6. Dispositif selon la revendication 4 ou 5, **caractérisé en ce que** lesdits moyens de commande et de détection (2) comprennent des moyens (ICI-A) de détection du courant circulant dans ledit au moins un thyristor (TIR).

7. Dispositif selon l'une quelconque des revendications précédentes, **caractérisé en ce que** lesdits moyens de commande et de détection (2) commandent des moyens de signalisation acoustiques et/ou visuels.

8. Dispositif selon la revendication 7, **caractérisé en ce que** lesdits moyens de signalisation acoustiques et/ou visuels (6) comprennent un dispositif d'affichage.

9. Dispositif selon l'une quelconque des revendications précédentes, **caractérisé en ce que** lesdits moyens d'alimentation (3) sont aptes à être connectés à une batterie (5) par des moyens de type pinces (BATT+, BATT_ELETTRONICA-), et **en ce que** lesdits moyens de commande et de détection (2) comprennent des moyens (R4, R5) de détection d'au moins une tension appliquée auxdits moyens de types pinces (BATT+, BATT_ELETTRONICA-).

10. Dispositif selon la revendication 9, quand elle dépend de la revendication 3, **caractérisé en ce que** lesdits moyens de commande et de détection (2), quand ils détectent que ladite au moins une tension appliquée n'est pas positive, sont aptes à commander lesdits moyens d'autorisation (4) afin de ne pas autoriser la circulation dudit courant vers/depuis la batterie (5).

11. Dispositif selon la revendication 9 ou 10, quand elle dépend de la revendication 3, **caractérisé en ce que** lesdits moyens de commande et de détection (2), quand ils détectent que ladite au moins une tension appliquée atteint au moins une valeur de tension de seuil correspondant, sont aptes à commander lesdits moyens d'autorisation (4) afin de ne pas autoriser la circulation dudit courant vers/depuis la batterie (5).

12. Dispositif selon la revendication 11, **caractérisé en ce que** ladite au moins une valeur de tension de seuil correspondante est sélectionnable par un utilisateur.

13. Dispositif selon l'une quelconque des revendications précédentes, quand elle dépend de la revendication 3, **caractérisé en ce que** lesdits moyens de commande et de détection (2) comprennent des moyens d'interruption activables par un utilisateur, à la suite de l'activation desquels lesdits moyens de commande et de détection (2) commandent lesdits moyens d'autorisation (4) afin de ne pas autoriser la circulation dudit courant vers/depuis la batterie (5).

**14.** Dispositif selon l'une quelconque des revendications précédentes, quand elle dépend de la revendication 3, **caractérisé en ce que** lesdits moyens de commande et de détection (2), quand ils détectent que ladite période de temps atteint une valeur de temps de seuil correspondant, sont aptes à commander lesdits moyens d'autorisation (4) afin de ne pas autoriser la circulation dudit courant vers/depuis la batterie (5).

**15.** Dispositif selon la revendication 14, **caractérisé en ce que** ladite valeur de temps de seuil est sélectionnable par un utilisateur

**16.** Dispositif selon l'une quelconque des revendications précédentes, **caractérisé en ce que** lesdits moyens de commande et de détection (2) sont aptes à détecter une performance énergétique $Re_t$, pour chaque cycle de recharge-décharge $t_t$, de ladite batterie (5), égale au rapport

$$Re_t = Wh_{0t}/Wh_{1t}$$

où $Wh_{0t}$ est l'énergie électrique pouvant être obtenue pendant une décharge de ladite batterie (5) au cycle t et $Wh_{1t}$ est l'énergie électrique nécessaire pour une recharge de ladite batterie (5) au cycle t.

**17.** Dispositif selon la revendication 16, **caractérisé en ce que** lesdits moyens de commande et de détection (2) sont aptes à détecter l'énergie électrique résiduelle $Wh_{int}$ de ladite batterie (5) pendant une phase de décharge pendant le cycle t, égale à

$$Wh_{int} = Re_{t-1}.Wh_{1t}\text{-}Wh_{ut}$$

où $Re_{t-1}$ est la performance énergétique de la recharge-décharge de ladite batterie (5) pendant le cycle précédent t-1, $Wh_{1t}$ est l'énergie électrique de recharge de ladite batterie (5) au cours du cycle t et $Wh_{ut}$ est l'énergie électrique obtenue par ladite batterie (5) avant sa décharge complète pendant ledit cycle t.

**18.** Dispositif selon l'une quelconque des revendications précédentes, quand elle dépend de la revendication 3, **caractérisé en ce que** lesdits moyens de commande et de détection (2) comprennent des moyens (NTC) de détection de la température desdits moyens d'autorisation (4).

**19.** Dispositif selon la revendication 18, **caractérisé en ce que** lesdits moyens de commande et de détection (2) activent au moins un ventilateur de refroidissement quand ils détectent que ladite température atteint une première valeur de température de seuil correspondant.

**20.** Dispositif selon la revendication 18 ou 19, **caractérisé en ce que** lesdits moyens de commande et de détection (2) quand ils détectent que ladite température atteint une deuxième valeur de température de seuil correspondant sont aptes à commander lesdits moyens d'autorisation (4) afin de ne pas autoriser la circulation dudit courant vers/depuis la batterie (5).

**21.** Dispositif selon l'une quelconque des revendications précédentes, **caractérisé en ce que** lesdits moyens de commande et de détection (2) activent au moins un ventilateur de refroidissement quand ils détectent que ledit courant électrique circulant vers/depuis la batterie (5) atteint une valeur de courant de seuil correspondant.

Fig. 1

## Fig. 2A

R26  R25
N$3  RQ  ICO
1  VDD  7  C10
28  VSS  3

A1  16
B1  19
C1  24
D1  22
E1  26
F1  25
G1  14
FAN  13

21  PTO
20  PT1
18  PT2
17  PT3  R33  SEL 1224

COUT1  2
COUT2  6
COUT3  8
COUT4  9
CONTROL  23
INVP  27
OUTOSC  5
INOSC  4

12  TEMP
11  VOLTAGE
10  CURR
15  SYNCRO

C6

## Fig. 2B

OUTOSC
INOSC

C8  RT1  R29  C3

GND

## Fig. 2C

CSYNCRO

R30

5 +
IC1B  7 SYNCRO
VSOGLIA  6 −

R31

## Fig. 2D

BATT+

R2

VOLTAGE

R3

BATT−

## Fig. 2E

C4  R23

1  3 +  8
R6  2 −  IC1A  1  CURR
4

R7

C2

12

Fig. 2F

Fig. 2G

Fig. 2H

Fig. 3A

Fig. 3B

Fig. 4

**EP 1 584 941 B1**

**REFERENCES CITED IN THE DESCRIPTION**

**Patent documents cited in the description**

* US 6501249 B1